# FASCICULE DE BREVET EUROPEEN

(11) **EP 3 756 506 B1**
(45) Date de publication et mention de la délivrance du brevet: **02.08.2023**
(21) Numéro de dépôt: 20181548.7
(22) Date de dépôt: 23.06.2020
(51) Int. Cl.: A47B 47/00, A47F 1/12, F16B 12/50, F16B 12/52, F16B 9/02, H05K 5/02, H05K 5/06, H05K 7/18

(54) **RACCORD D'ANGLE POUR L'ASSEMBLAGE D'UNE ARMATURE MÉTALLIQUE**
WINKELVERBINDUNG FÜR DIE MONTAGE METALLARMATUREN
CORNER CONNECTOR FOR ASSEMBLING A METAL FRAME

(30) Priorité: 24.06.2019 FR 1906795
(43) Date de publication de la demande: 30.12.2020
(73) Titulaire: Schneider Electric Industries SAS, 92500 Rueil Malmaison (FR)
(72) Inventeur: DESCHANG, Fabien, 38050 Grenoble Cedex 09 (FR); LEHMANN, Francis, 38050 Grenoble Cedex 09 (FR); BUCHY, Stéphane, 38050 Grenoble Cedex 09 (FR)
(74) Mandataire: Lavoix

(56) Documents cités:
- GB-A- 2 152 174
- JP-A- 2006 105 180
- KR-A- 20020 021 309
- US-A1- 2016 073 527

## Description

L'invention concerne un raccord d'angle pour l'assemblage d'une armature métallique, ainsi qu'une armature métallique comportant un tel raccord d'angle.

En général, les armoires électriques destinées à accueillir divers appareils électriques, tels que des alimentations, des automates, des disjoncteurs, etc., sont constituées d'une armature rigide de forme de pavé à laquelle sont fixés les divers appareils électriques précités, ou bien des étagères supportant ces appareils. L'armature est constituée de rails et de montants formés par des profilés métalliques assemblés par des raccords d'angle, ces derniers étant placés au niveau des huit coins du pavé. Des panneaux de protection ou des portes peuvent aussi être fixés à cette armature pour former des parois de l'armoire électrique. Pour des raisons pratiques, une telle armature est généralement partiellement assemblée en usine, le montage étant ensuite finalisé sur site. Par exemple, des rails, coupés aux dimensions voulues, sont assemblés en usine à quatre raccords d'angle pour constituer deux cadres de forme rectangulaire, et ces deux cadres sont ensuite assemblés sur site à quatre montants de longueur identique, cet assemblage se faisant au niveau des raccords d'angle.

Pour des raisons de facilité d'assemblage, un raccord d'angle comprenant un nombre réduit de pièces est souhaitable. Un tel raccord d'angle doit en outre présenter une grande résistance mécanique ainsi qu'une durabilité la plus élevée possible, notamment en limitant les infiltrations d'eau de lavage ou de condensation.

GB-2 152 174-A décrit un raccord d'angle permettant l'assemblage d'un cadre, formé de rails horizontaux, à des montants verticaux. Cependant ce raccord d'angle n'empêche pas les infiltrations d'eau. US 2016/073527 A1 décrit aussi un raccord d'angle de l'art antérieur considéré comme proche de l'invention puisqu'il comprend un joint. à

C'est à ces problèmes qu'entend plus particulièrement répondre l'invention, en proposant un raccord d'angle pour une armature d'armoire électrique, ce raccord d'angle étant facile à assembler avec un nombre réduit de pièces, offrant une grande résistance mécanique et étant durable, notamment vis-à-vis des intrusions d'eau.

À cet effet, l'invention concerne un raccord d'angle, destiné à être assemblé à deux rails qui définissent ensemble un premier plan horizontal, et à un montant vertical pour former une armature. Le raccord d'angle comprend une pièce de raccord, une vis et un élément taraudé coopérant avec la vis. La vis comprend une tête et une tige filetée alignées selon un premier axe, le montant présente un contour et définit un logement avant l'élément taraudé s'étend suivant un deuxième axe et est configuré pour être monté fixe au sein du logement avant. La pièce de raccord présentant un trou d'axe vertical, avec un épaulement interne orienté à l'opposé de l'élément taraudé, et la vis coopère conjointement avec l'épaulement interne de la pièce de raccord et avec l'élément taraudé. Selon l'invention, la pièce de raccord comprend une gorge en forme de W, configurée pour coopérer avec un contour en forme de W du montant, alors que le raccord d'angle comprend un organe d'étanchéité, interposé entre la gorge en forme de W et le contour en forme de W lorsque ce contour en forme de W est situé en regard de la gorge en forme de W.

Grâce à l'invention, l'assemblage du raccord d'angle au montant vertical est facile à réaliser sur site, notamment à l'aide d'outils usuels, et compte un nombre réduit de pièces tout en garantissant un montage limitant les infiltrations d'eau et une grande résistance mécanique. Selon des aspects avantageux mais non obligatoires de l'invention, un tel raccord d'angle peut incorporer une ou plusieurs des caractéristiques suivantes, prises selon toute combinaison techniquement admissible :
- La pièce de raccord comprend des surfaces d'appui qui coopèrent avec le contour du montant et sont aptes à transférer les efforts axiaux parallèles à l'axe du montant.
- La pièce de raccord comprend une première protubérance, alors que le montant définit un logement arrière avec une ouverture, et que la première protubérance coopère avec l'ouverture du logement arrière pour immobiliser en rotation la pièce de raccord par rapport au montant et étant apte à aligner la pièce de raccord par rapport au montant et à transférer les efforts de torsion entre le montant et la pièce de raccord.
- La pièce de raccord comprend des deuxièmes protubérances, qui coopèrent avec le logement avant et sont aptes à aligner la pièce de raccord par rapport au montant et à transférer les efforts de cisaillement et de torsion entre le montant et la pièce de raccord.
- L'organe d'étanchéité présente un contour ouvert.
- L'organe d'étanchéité est réalisé en un matériau élastomère, de préférence en éthylène - propylène - diène - monomère.
- L'élément taraudé présente une surface latérale polygonale qui bloque la rotation de l'élément taraudé par rapport au montant.

Avantageusement, l'assemblage du raccord d'angle au montant est apte à transmettre des efforts de torsion et de cisaillement entre le montant et le raccord d'angle, et la vis n'est sollicitée qu'en traction.

Avantageusement, le raccord d'angle comprend un organe d'étanchéité qui évite les infiltrations d'eau dans le montant.

L'invention concerne également une armature, qui comprend au moins deux rails, un montant et un raccord d'angle selon l'invention, alors que les deux rails sont mécaniquement connectés à la pièce d'angle et définissent ensemble un premier plan, alors que le montant et les deux rails définissent ensemble en trièdre rectangle dont le raccord d'angle est le sommet.

Grâce à l'invention, l'armature comprenant un raccord d'angle selon l'invention offre une rigidité élevée, ce qui permet d'installer des équipements électriques plus lourds sans avoir à les répartir dans deux ou plusieurs armoires électriques, ce qui est particulièrement économique. L'armature présente aussi une résistance élevée aux infiltrations d'eau, ce qui favorise la durabilité des équipements électriques placés dans l'armoire électrique comprenant une telle armature.

L'invention sera mieux comprise, et d'autres avantages de celle-ci apparaîtront plus clairement à la lumière de la description qui va suivre, d'un mode de réalisation d'un raccord d'angle ainsi que d'une armature comprenant un raccord d'angle conforme à son principe, donnée uniquement à titre d'exemple et faite en référence aux dessins, dans lesquels :
[Fig 1] la figure 1 est une vue en perspective d'une armature d'armoire électrique conforme à des modes de réalisation de l'invention ;
[Fig 2] la figure 2 est une vue en perspective éclatée d'un raccord d'angle de l'armature de la figure 1, repéré par la flèche II sur la figure 1 ;
[Fig 3] la figure 3 est une vue analogue à celle de la figure 2, suivant un autre angle de vue repéré par la flèche III sur la figure 1 ;
[Fig 4] la figure 4 est une coupe, suivant le plan IV repéré sur la figure 1, d'un raccord d'angle conforme à des modes de réalisation de l'invention.

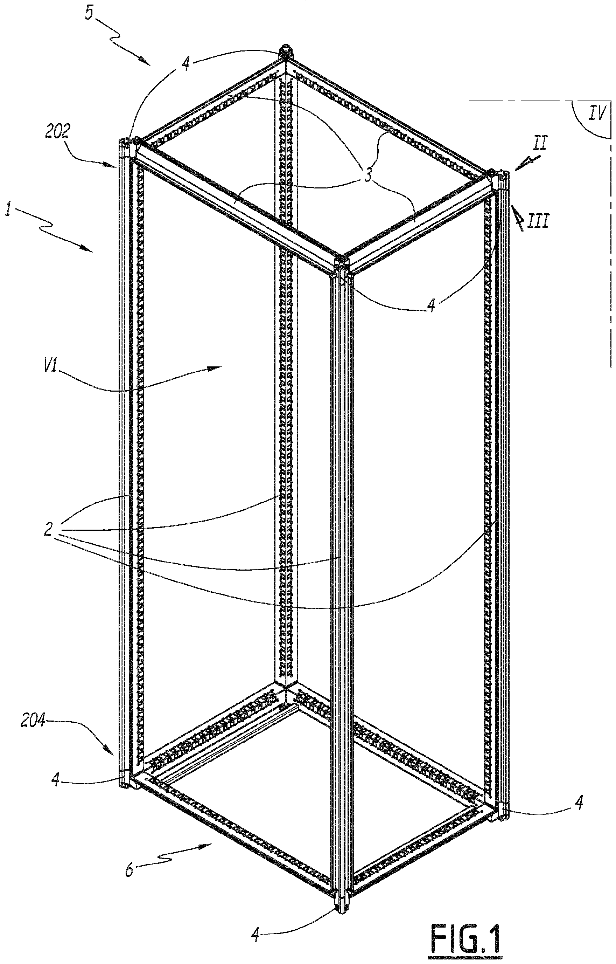

La figure 1 représente une armature 1, utilisée par exemple comme structure porteuse d'une armoire électrique.

L'armature 1 est représentée posée sur une surface horizontale. L'armature 1 présente une forme de pavé, et définit un volume interne V1.

L'armature 1 comprend quatre montants 2 disposés verticalement, par exemple de façon à former les arêtes latérales dudit pavé. Les montants 2 relient un cadre haut 5 à un cadre bas 6. Les cadres comprennent chacun quatre rails 3, disposés sur les arêtes des faces supérieure et inférieure du pavé, et quatre raccords d'angle 4, un raccord d'angle 4 étant situé à chacun des coins des cadre 5 et 6.

Avantageusement, tous les raccords d'angle 4 présentent ici la même forme, ce qui simplifie la fabrication et la gestion des stocks de pièces détachées. En variante non représentée, les raccords d'angle 4 peuvent présenter des formes différentes.

Par commodité, un seul raccord d'angle 4 est décrit dans la suite.

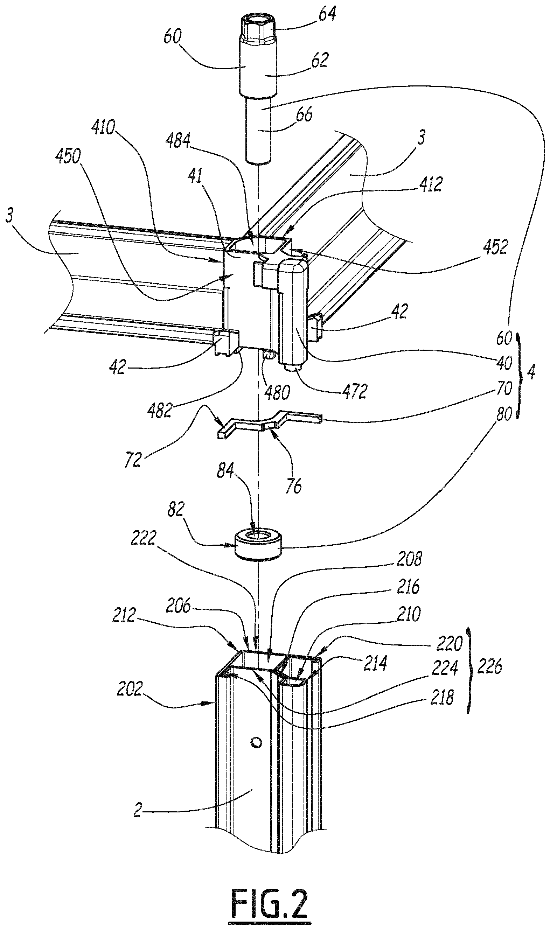

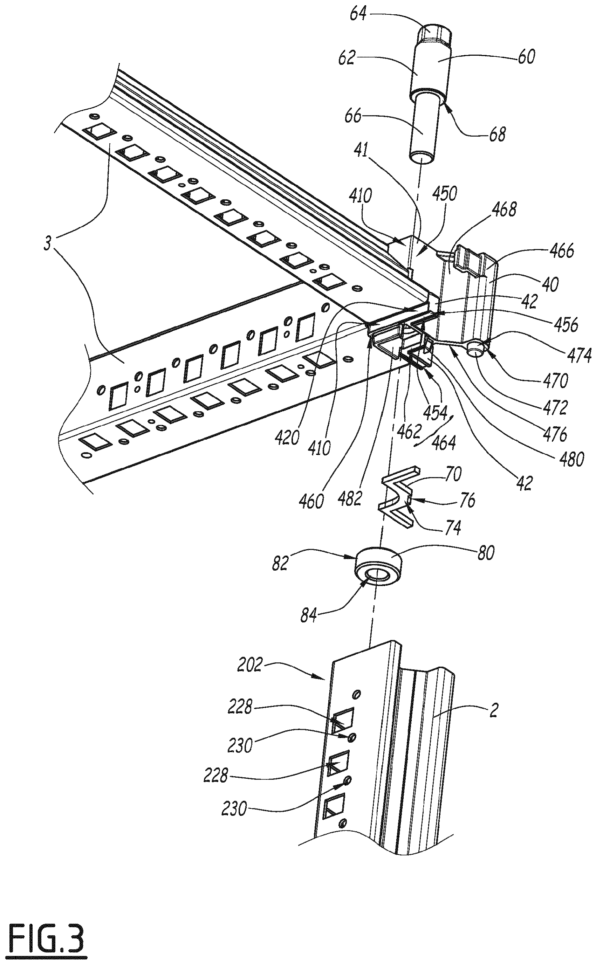

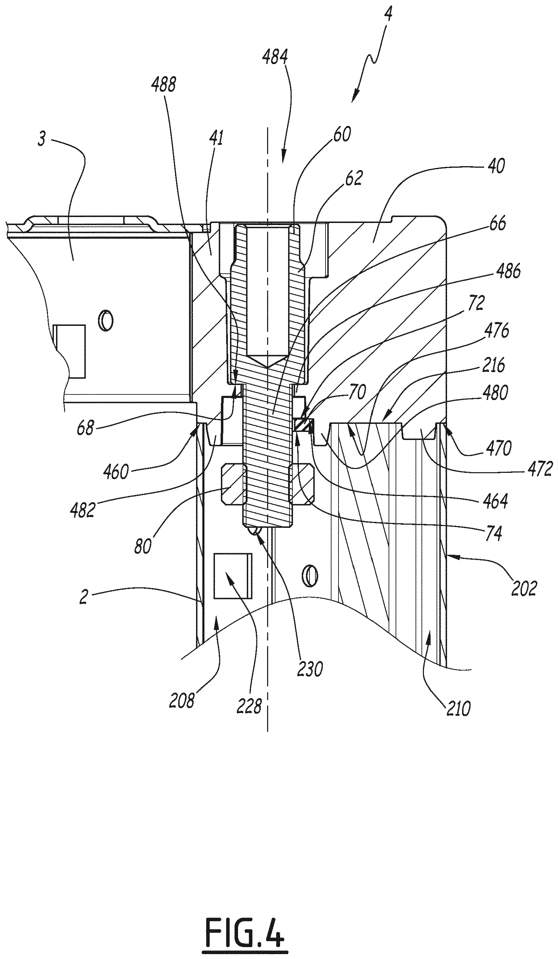

Un seul raccord d'angle 4 est représenté en perspective éclatée sur les figures 2 et 3, et en coupe sur la figure 4.

De façon analogue, les quatre montants 4 présentent chacun une structure identique les uns aux autres, tandis que les rails 3 des cadres haut 5 et bas 6 sont identiques les uns aux autres.

Les rails 3 et les montants 2 sont réalisés en métal, de préférence en acier galvanisé, cet exemple n'étant pas limitatif.

Selon des exemples, des parois peuvent être montés sur l'armature pour couvrir des faces de l'armature 1 et fermer au moins partiellement le volume V1. Par exemple, les parois sont des portes ou des panneaux.

Un seul des montants 2 est représenté sur les figures 2 à 4, et par commodité un seul montant 2 est décrit dans la suite. Toutefois, la description qui est faite de ce montant 2 est applicable aux autres montants 2.

Selon des exemples, comme illustré aux figures 2 à 4, le montant 2 est un profilé disposé verticalement dans sa longueur, qui présente une extrémité haute 202, une extrémité basse 204, avec un contour 206 constant sur toute la longueur du profilé 2. Le contour 206 est situé dans un plan orthogonal à l'axe du montant 2, c'est-à-dire ici dans un plan horizontal.

Le montant 2 définit un logement avant 208 et un logement arrière 210. Le logement avant 208 est plus proche du volume interne V1 que le logement arrière 210.

Par commodité, dans la suite de la description les termes « avant » et « arrière » sont définis respectivement comme « orienté vers le volume interne V1 » et « orienté à l'opposé du volume interne V1 ».

Le logement avant 208 débouche du contour 206 par une première section carrée 212, tandis que le logement arrière 210 débouche du contour 206 par une deuxième section carrée 214. La première section carrée 212 et la deuxième section carrée 214 sont reliées par un prolongement central 216.

La première section carrée 212 est prolongée sur les côtés par un premier prolongement latéral 218 et par un deuxième prolongement latéral 220, respectivement orientés vers la gauche et vers la droite sur l'exemple de la figure 2.

La première section carrée 212 est, en outre, partagée entre une partie avant 222 et une partie arrière 224, la partie avant 222 comprenant les deux côtés de la première section carrée 212 qui forment un angle orienté vers l'avant, tandis que la partie arrière 224 comprend les deux autres côtés, qui forment un angle orienté vers l'arrière, c'est-à-dire à l'opposé du volume interne V1.

Le sous-ensemble formé par le premier prolongement latéral 218, la partie arrière 224 de la première section carrée 212 et le deuxième prolongement latéral 220 définit un contour, en forme de W, qui porte ici la référence 226. Autrement dit, le contour 226 représente une partie du contour 206 de l'extrémité haute 202 du montant 2. Dit encore autrement, le contour 206 du montant 2 comprend un contour en forme de W 226.

Le montant 2 comporte, sur les faces orientées vers le volume interne V1, des ouvertures rectangulaires 228 et des trous 230, visibles sur les figures 3 et 4. Les ouvertures rectangulaires 228 et les trous 230 coopèrent avec des organes de fixation, de préférence réversibles, qui fixent les divers appareils électriques et / ou accessoires et / ou les parois précédemment mentionnées à l'armature 1 au sein du volume interne V1. Les organes de fixation, les parois et les divers appareils électriques ne sont pas représentés.

On décrit à présent l'écrou 80.

L'écrou 80 présente ici la forme d'un cylindre de section circulaire de génératrice verticale, et définit une surface latérale 82. Un alésage taraudé 84 est ménagé au travers de l'écrou 80, suivant un axe vertical. L'écrou 80 est réalisé en métal, de préférence en acier.

L'écrou 80 est logé dans le logement avant 208 du montant 2, et est mécaniquement connecté au montant 2, par exemple par soudage, notamment par soudage par résistance, par soudage laser ou par soudage par apport de matière, ces exemples de méthode d'assemblage n'étant pas limitatifs. L'axe de l'alésage taraudé 84 est ainsi parallèle à l'axe du montant 2, voire aligné avec ce dernier.

L'écrou 80 est un exemple de réalisation d'un élément taraudé. En variante non représentée, l'écrou 80 peut présenter d'autres formes, par exemple la forme d'un cylindre de section polygonale, notamment de section carrée, hexagonale ou octogonale, coopérant avec le logement avant 208. Avantageusement, un écrou 80 présentant une forme carrée ou octogonale est bloqué en rotation par rapport au montant 2 lorsque l'écrou 80 est logé dans le logement avant 208, qui présente ici une section carrée. La surface latérale 82 de l'écrou 80 présente alors des facettes, certaines de ces facettes étant en appui plan sur les parois internes du logement avant 208, ce qui facilite le soudage.

On décrit à présent le joint 70.

Le joint 70 présente une face supérieure 72, orientée vers le haut, et une face inférieure 74 orientée vers le bas. Les faces supérieure 72 et inférieure 74 sont parallèles entre elles, et sont ici horizontales. Le joint 70 présente ici une forme en W, qui coopère avec le contour 226 du montant 2, lui aussi en forme de W dans l'exemple des figures. Le joint 70 présente une encoche 76, située dans un plan vertical orienté vers l'arrière.

Le joint 70 est réalisé en un matériau élastomère, de préférence en « éthylène - propylène - diène - monomère », dit aussi EPDM, cet exemple n'étant pas limitatif.

Le joint 70 assure l'étanchéité du contour 226 sur lequel la face inférieure 74 du joint 70 est en appui.

On décrit à présent la pièce de raccord 40. Dans cette description, la pièce de raccord 40 décrite appartient au cadre supérieur 5. Les notions de « haut » et de « bas » sont donc, dans ce qui suit pour la description de cette pièce de raccord 40, définis en référence à cette position de la pièce de raccord 40. Dans certains exemples, le cadre inférieur 6 et inversé symétriquement par rapport au cadre supérieur 5. L'orientation de la pièce de raccord 40 du cadre 6 est alors adaptée en conséquence.

La pièce de raccord 40 est réalisée en métal, de préférence en acier, et est obtenue par moulage, notamment par moulage à cire perdue, ces exemples de matériaux et de mode de production n'étant pas limitatifs.

La pièce de raccord 40 comprend un corps principal 41. Le corps principal 41 présente une forme cylindrique de génératrice verticale et de section polygonale, de préférence une section quadrilatère, notamment une section rectangulaire. Le corps principal 41 présente deux faces latérales avant 410 et 412, qui sont orientées vers l'avant, ainsi que deux faces latérales arrière 450 et 452, orientées vers l'arrière. Les deux faces latérales avant 410 et 412 sont situées dans des plans verticaux et orthogonaux entre eux.

Les deux faces latérales avant 410 et 412 présentent chacune une arête basse commune avec un rebord avant 460 du corps principal 41. Le rebord avant 460 est horizontal.

La pièce de raccord 40 comprend aussi deux excroissances 42. Les deux excroissances 42 s'étendent horizontalement en saillie des faces latérales arrière 450 et 452 en s'éloignant du volume interne V1. Par exemple, les deux excroissances 42 sont en forme de trapèze et présentent chacune une face latérale 420 et une face inférieure 454. La face latérale 420 de chaque excroissance 42 est située dans le prolongement d'une des faces latérales avant 410 et 412.

Les deux faces latérales arrière 450 et 452 présentent chacune une arête basse commune avec une gorge arrière 462. La gorge arrière 462 a un profil en U ouvert vers le bas, et présente, dans un plan horizontal, une forme de V.

Une gorge latérale 456 est en outre ménagée dans la face inférieure 454 de chaque excroissance 42.

Les deux gorges latérales 456 et la gorge arrière 462 forment ensemble une gorge qui porte la référence 464, dont le fond est continu, horizontal, et présente une forme de W, analogue à la forme du joint 70. Autrement dit, la pièce de raccord 40 comprend une gorge en forme de W 464.

La gorge 464 est apte à accueillir le joint 70, la face supérieure 72 du joint 70 étant en appui étanche sur le fond de la gorge 464. En d'autres termes, le joint 70 est superposé avec la gorge 464 lorsqu'il est reçu dans celle-ci entre la gorge 464 et l'extrémité supérieure 202 du montant 2.

La pièce de raccord 40 comprend aussi un corps arrière 466, relié au corps principal 41 par une paroi centrale 468.

La paroi centrale 468 présente un rebord inférieur 476, qui est horizontal.

Le corps arrière 466 a une forme de cylindre de section carrée et de génératrice verticale, et présente une face inférieure 470. La face inférieure 470 et le rebord inférieur 476 sont coplanaires entre eux, ainsi qu'avec le rebord avant 460.

Un plot 472 est ménagé en saillie sur la face inférieure 470 du corps arrière 466. Selon des exemples, le plot 472 présente une forme tronconique qui définit une surface latérale 474. La forme en tronçon de cône du plot 472 présente un axe confondu avec l'axe du corps arrière 466, la base du tronçon de cône est liée à la face inférieure 470 et la face opposée à l'embase est plus petite que la base et orientée vers le bas.

Le plot 472 est un exemple de réalisation d'une première protubérance, qui est logée dans le logement arrière 210 du montant 2.

Le sous-ensemble formé par la face inférieure 470, le rebord inférieur 476, le rebord avant 460 et la gorge 464 constitue le profil de la face inférieure de la pièce de raccord 40. Autrement dit la gorge 464 représente une partie de ce profil.

La pièce de raccord 4 comprend, en outre, un ergot 480 et une paroi 482 en forme de V. Par exemple, l'ergot 480 présente une forme de tronçon de cône à base triangulaire, ménagé en saillie sur la face inférieure du corps principal 41 dans l'angle le plus éloigné du volume interne V1. L'ergot 480 coopère avec l'encoche 76 du joint 70, contribuant au positionnement du joint 70 dans la gorge 464 lors du montage du raccord d'angle 4 sur le montant 2.

Lors de l'assemblage du raccord d'angle 4 et du montant 2, le positionnement du joint 70 dans la gorge 464 est aisé, ce qui est source de gain de temps et donc de productivité. Avantageusement, le joint 70 présente un contour ouvert, plus facile à positionner dans la gorge 464 qu'un joint à contour fermé, ce qui facilite l'assemblage du raccord d'angle 4 sur site.

La paroi 482 est ménagée en saillie et vers le bas sur les rebords avant 460 du corps principal 41.

La paroi 482 et l'ergot 480 constituent ensemble un exemple de deuxièmes protubérances, qui coopèrent conjointement avec le logement avant 208, contribuant au centrale de la pièce de raccord 40 par rapport au montant 2 lors du montage, et une fois montés, la paroi 482 et l'ergot 480 contribuent à transmettre les efforts de torsion entre le montant 2 et le raccord d'angle 4.

La pièce de raccord 40 comprend, en outre, un trou 484. Le trou 484 traverse verticalement de part en part la pièce de raccord 40. Un anneau 486 est ménagé horizontalement et en saillie au sein du trou 484. L'anneau 486 est circulaire et coaxial au trou 484. L'anneau 486 définit une surface supérieure 488, plane et horizontale, qui constitue un exemple d'épaulement interne.

On décrit à présent la vis 60.

Selon des exemples, la vis 60 comprend une tête 62 de forme cylindrique et de génératrice verticale, qui présente à une extrémité haute un profil hexagonal 64, et à l'autre extrémité une tige filetée 66. La vis 60 présente un épaulement 68, l'épaulement 68 étant situé à la jonction de la tige filetée 66 à la tête 62.

Lorsque le raccord d'angle 4 est assemblé au montant 2, ainsi que représenté en figure 4, la tige filetée 66 traverse l'anneau 486 et coopère avec l'écrou 80. L'épaulement 68 est alors en appui sur la surface supérieure 488 de l'anneau 86, tandis que la tête 62 de la vis 60 est entièrement logée dans le trou 484. En d'autres termes, la vis 60 coopère conjointement avec l'épaulement interne de la pièce de raccord, ici formé par la surface supérieure 488, et avec l'écrou 80.

Avantageusement, la surface supérieure 488 peut être usinée pour en améliorer l'état de surface, notamment la rugosité et la planéité, ce qui améliore le contact entre l'épaulement 68 de la vis 60 et réduit le risque de rupture prématurée de la vis 60.

Le serrage de la vis 60 crée une force de traction verticale qui rapproche le montant 2 de la pièce de raccord 40. La face inférieure 470 du corps arrière 466 est alors en appui sur la deuxième section carrée 214 du logement arrière 210, tandis que le rebord inférieur 476 de la paroi centrale 468 est en appui sur le prolongement central 216 du contour 206 du montant 2, et le rebord avant 460 du corps principal 41 est en appui sur la partie avant 222 de la première section carrée 212. Le rebord avant 460, la face inférieure 470 et le rebord inférieur 476 constituent ensemble des surfaces d'appui de la pièce de raccord 40, qui coopèrent avec le contour 206 du montant 2 et contribuent au transfert des efforts axiaux, c'est-à-dire parallèles à l'axe du montant 2, entre le montant 2 et le raccord d'angle 4.

Le plot 472, qui constitue un exemple de première protubérance, est logé dans le logement arrière 210, ce qui crée un obstacle à la rotation de la pièce de raccord 40 par rapport au montant 2 autour d'un axe vertical parallèle à l'axe de la tige filetée 66 de la vis 60. En d'autres termes, la première protubérance coopère avec l'ouverture 214 du logement arrière 210 pour immobiliser en rotation la pièce de raccord 40 par rapport au montant 2. Le plot 472 est un exemple de réalisation d'un pion d'alignement, apte à aligner la pièce de raccord par rapport au montant lors du montage, et contribue à transférer les efforts de torsion entre le montant 2 et la pièce de raccord 40 une fois le raccord d'angle 40 assemblé au montant 2.

L'ergot 480 et la paroi 482 constituent ensemble un exemple de deuxièmes protubérances et coopèrent avec le logement avant 208, qui présente une section carrée.

Les deuxièmes protubérances contribuent ainsi à l'alignement de la pièce de raccord 40 par rapport au montant 2 lors du montage, et une fois que le raccord d'angle 4 est assemblé, les deuxièmes protubérances transfèrent les efforts de cisaillement entre la pièce de raccord 40 et le montant 2. Ces efforts de cisaillement sont, autrement dit, les efforts tranchants situés dans un plan horizontal. La vis 60 n'est ainsi pas sollicitée par ces efforts de cisaillement qui sont orthogonaux à l'axe de la vis 60, ce qui évite une rupture prématurée de la vis 60, et donc contribue à la durabilité de l'armature 1.

La forme anguleuse de l'ergot 480 et de la paroi 482 coopère avec la forme de la première section carrée 212, ce qui contribue aussi à transférer les efforts de torsion entre le montant 2 et la pièce de raccord 40.

Pour une géométrie donnée du contour 206 du montant 2, le plot 472 et la paroi 482 sont le plus éloigné possible l'un de l'autre, ce qui maximise la reprise des efforts de torsion entre le montant 2 et le raccord d'angle 4. Cela contribue à la résistance mécanique de l'armature 1.

Le joint 70 est conjointement logé dans la gorge 464, c'est-à-dire que le joint 70 est en appui sur le fond de la gorge 464, et est en appui sur le contour 226. Autrement dit le joint 70 est interposé entre la gorge en forme de W 464 et le contour en forme de W 226.

La gorge 464 et le contour 226 présentent des contours analogues, en ce sens que la gorge 464 et le contour 226 coopèrent conjointement avec les deux faces supérieure 72 et inférieure 74 du même joint 70. Grâce à la première protubérance 472 et aux deuxièmes protubérances 480 et 482, la pièce de raccord 40 est alignée horizontalement avec le montant 2. En particulier, en projection sur un plan horizontal, le fond de la gorge 464, en forme de W, est superposé avec le contour 226 en forme de W.

Le joint 70 ne fait effet que pour l'étanchéité, alors que la rigidité du raccord d'angle 4 assemblé au montant 2 est assurée grâce au serrage de la vis 60 et au contact des surfaces métalliques du raccord d'angle 4 contre les surfaces métalliques du montant 2 : le rebord avant 460, le rebord inférieur 476 et la face inférieure470 pour le raccord d'angle 4 et, pour le montant 2, le premier prolongement latéral 218, la première section carrée 212, le deuxième prolongement latéral 220, la deuxième section carrée 214 et le prolongement central 216.

La profondeur de la gorge 464 est adaptée pour accueillir le joint 70, en ce sens que, lorsque le raccord d'angle 4 est assemblé au montant 2 et que la vis 60 est serrée, la gorge 464 présente une profondeur assez réduite pour que le joint 70 soit comprimé selon la direction verticale pour garantir une bonne étanchéité, la gorge 464 étant suffisamment profonde pour que le joint 70 ne soit pas endommagé par écrasement.

Les rails 3 présentent un profil qui coopère avec la première surface latérale avant 410 du corps principal 41, la deuxième surface latérale avant 412 du corps principal 41, et les faces latérales 420 des excroissances 42. Par exemple, les surfaces latérales 410 et 412 sont chacune pourvue d'une portion de réception, telle qu'un logement creux ou un embout, pour recevoir une extrémité correspondante d'un rail 3. En configuration assemblée de l'armature 1, les rails 3 sont mécaniquement connectés à la pièce de raccord 40, notamment par soudage.

Les deux rails 3 représentés sur les figures 2 et 3 sont ainsi orthogonaux entre eux, situés dans un même plan horizontal, et se rejoignent au niveau du raccord d'angle 4. Le montant 2 représenté sur les figures 2 et 4 est vertical, et coupe le plan formé des deux rails 3 au niveau du raccord d'angle 4. Autrement dit, les deux rails 3 et le montant 2 définissent ensemble un trièdre rectangle, dont le sommet est le raccord d'angle 4.

Sur l'exemple de la figure 1, l'armature 1 comprend huit raccords d'angle 4, et chaque raccord d'angle 4 est connecté à deux rails 3 et à un montant 2, formant un trièdre rectangle dont ce raccord d'angle 4 est le sommet.

Le mode de réalisation et les variantes mentionnés ci-dessus peuvent être combinés entre eux pour générer de nouveaux modes de réalisation de l'invention.

## Revendications

1. Raccord d'angle (4), destiné à être assemblé à deux rails (3) définissant ensemble un premier plan horizontal et à un montant (2) vertical pour former une armature (1), dans lequel le raccord d'angle comprend une pièce de raccord (40), une vis (60) et un élément taraudé (80) coopérant avec la vis, la vis comprenant une tête (62) et une tige filetée (66) alignées selon un premier axe, le montant présentant un contour (206) et définissant un logement avant (208), l'élément taraudé s'étendant suivant un deuxième axe et étant configuré pour être monté fixe au sein du logement avant, la pièce de raccord présentant un trou (484) d'axe vertical, avec un épaulement interne (488) orienté à l'opposé de l'élément taraudé, alors que la vis coopère conjointement avec l'épaulement interne de la pièce de raccord et avec l'élément taraudé, **caractérisé en ce que** la pièce de raccord (40) comprend une gorge en forme de W (464), configurée pour coopérer avec un contour en forme de W (226) du montant (2), et **en ce que** le raccord d'angle (4) comprend un organe d'étanchéité (70), configuré pour être interposé entre la gorge en forme de W (464) et le contour en forme de W (226) lorsque ce contour en forme de W est situé en regard de la gorge en forme de W.

2. Raccord d'angle (4) selon la revendication précédente, **caractérisé en ce que** la pièce de raccord (40) comprend des surfaces d'appui (460, 470, 476) qui sont configurées pour coopérer avec le contour (206) du montant (2) et sont aptes à transférer les efforts axiaux parallèles à l'axe du montant.

3. Raccord d'angle (4) selon l'une quelconque des revendications précédentes, **caractérisé en ce que** la pièce de raccord (40) comprend une première protubérance (472), **en ce que** le montant (2) définit un logement arrière (210) avec une ouverture (214), **en ce que** la première protubérance est configurée pour coopérer avec l'ouverture du logement arrière pour immobiliser en rotation la pièce de raccord par rapport au montant et étant apte à aligner la pièce de raccord par rapport au montant et à transférer les efforts de torsion entre le montant et la pièce de raccord.

4. Raccord d'angle (4) selon l'une quelconque des revendications précédentes, **caractérisé en ce que** la pièce de raccord (40) comprend des deuxièmes protubérances (480, 482), qui sont configurées pour coopérer avec le logement avant (208) et sont aptes à aligner la pièce de raccord par rapport au montant (2) et à transférer les efforts de cisaillement et de torsion entre le montant et la pièce de raccord.

5. Raccord d'angle (4) selon l'une quelconque des revendications précédentes, **caractérisé en ce que** l'organe d'étanchéité (70) présente un contour ouvert.

6. Raccord d'angle (4) selon l'une quelconque des revendications précédentes, **caractérisé en ce que** l'organe d'étanchéité (70) est réalisé en un matériau élastomère, de préférence en éthylène - propylène - diène - monomère.

7. Raccord d'angle (4) selon l'une quelconque des revendications précédentes, **caractérisé en ce que** l'élément taraudé (80) présente une surface latérale (82) polygonale qui est configurée pour bloquer la rotation de l'élément taraudé par rapport au montant (2).

8. Armature (1) comprenant au moins deux rails (3), un montant (2) et un raccord d'angle (4), **caractérisée en ce que** le raccord d'angle est selon l'une quelconque des revendications précédentes, **en ce que** les deux rails sont mécaniquement connectés à la pièce d'angle (40) et définissent ensemble un premier plan, et **en ce que** le montant et les deux rails définissent ensemble en trièdre rectangle dont le raccord d'angle est le sommet.

## Patentansprüche

1. Eckverbinder (4), der dazu bestimmt ist, an zwei Schienen (3), die zusammen eine erste horizontale Ebene definieren, und an einem vertikalen Pfosten (2), um ein Gerüst (1) zu bilden, zusammengebaut zu werden, wobei die Eckverbindung ein Anschlussstück (40), eine Schraube (60) und ein mit der Schraube zusammenwirkendes Gewindeelement (80) umfasst, die Schraube umfassend einen Kopf (62) und eine Gewindestange (66), die entlang einer ersten Achse ausgerichtet sind, wobei der Pfosten eine Kontur (206) aufweist und eine vordere Aufnahme (208) definiert, das Gewindeelement sich entlang einer zweiten Achse erstreckt und konfiguriert ist, um fest innerhalb der vorderen Aufnahme montiert zu werden, und das Anschlussstück ein Loch (484) mit vertikaler Achse aufweist, mit einer inneren Schulter (488), die von dem Gewindeelement weg gerichtet ist, während die Schraube gemeinsam mit der inneren Schulter des Anschlussstücks und mit dem Gewindeelement zusammenwirkt, **dadurch gekennzeichnet, dass** das Anschlussstück (40) eine W-förmige Nut (464) umfasst, konfiguriert ist, um mit einer W-förmigen Kontur (226) des Pfostens (2) zusammenzuwirken, und dass der Eckverbinder (4) ein Dichtungselement (70) umfasst, das konfiguriert ist, um zwischen der W-förmigen Nut (464) und der W-förmigen Kontur (226) eingefügt zu werden, wenn sich diese W-förmige Kontur gegenüber der W-förmigen Nut befindet.

2. Eckverbinder (4) nach dem vorherigen Anspruch, **dadurch gekennzeichnet, dass** das Anschlussstück (40) Anlageflächen (460, 470, 476) umfasst, die konfiguriert sind, um mit der Kontur (206) des Pfostens (2) zusammenzuwirken und geeignet sind, um axiale Kräfte parallel zu der Achse des Pfostens zu übertragen.

3. Eckverbinder (4) nach einem der vorherigen Ansprüche, **dadurch gekennzeichnet, dass** das Anschlussstück (40) einen ersten Vorsprung (472) umfasst, dass der Pfosten (2) eine hintere Aufnahme (210) mit einer Öffnung (214) definiert, dass der erste Vorsprung konfiguriert ist, um mit der Öffnung der hinteren Aufnahme zusammenzuwirken, um das Anschlussstück in Bezug auf den Pfosten drehfest zu machen, und geeignet ist, um das Anschlussstück in Bezug auf den Pfosten auszurichten und die Torsionskräfte zwischen dem Pfosten und dem Anschlussstück zu übertragen.

4. Eckverbinder (4) nach einem der vorherigen Ansprüche, **dadurch gekennzeichnet, dass** das Anschlussstück (40) zweite Vorsprünge (480, 482) umfasst, die konfiguriert sind, um mit der vorderen Aufnahme (208) zusammenzuwirken und geeignet sind, um das Anschlussstück in Bezug auf den Pfosten (2) auszurichten und Scher- und Torsionskräfte zwischen dem Pfosten und dem Anschlussstück zu übertragen.

5. Eckverbinder (4) nach einem der vorherigen Ansprüche, **dadurch gekennzeichnet, dass** das Dichtungselement (70) eine offene Kontur aufweist.

6. Eckverbindung (4) nach einem der vorherigen Ansprüche, **dadurch gekennzeichnet, dass** das Dichtungsorgan (70) aus einem Elastomermaterial, vorzugsweise aus Ethylen-Propylen-Dien-Monomer gefertigt ist.

7. Eckverbinder (4) nach einem der vorherigen Ansprüche, **dadurch gekennzeichnet, dass** das Gewindeelement (80) eine polygonale Seitenfläche (82) aufweist, die konfiguriert ist, um die Drehung des Gewindeelements in Bezug auf den Pfosten (2) zu blockieren.

8. Gerüst (1), umfassend mindestens zwei Schienen (3), einen Pfosten (2) und einen Eckverbinder (4), **dadurch gekennzeichnet, dass** der Eckverbinder gemäß einem der vorherigen Ansprüche ist, dass die zwei Schienen mechanisch mit dem Winkelstück (40) verbunden sind und zusammen eine erste Ebene definieren, und das der Pfosten und die zwei Schienen zusammen ein rechtwinkliges Dreieck definieren, dessen Spitze der Eckverbinder ist.

## Claims

1. A corner connector (4), intended to be joined to two rails (3) together defining a first horizontal plane and to a vertical upright (2) to form a frame (1), wherein the corner connector comprises a connector part (40), a screw (60) and an internally-threaded element (80) mating with the screw, the screw comprising a head (62) and an externally-threaded shank (66) aligned along a first axis, the upright having a contour (206) and defining a front housing (208), the internally-threaded element extending along a second axis and being configured to be fixedly mounted within the front housing, the connector having a hole (484) with a vertical axis, with an internal shoulder (488) facing away from the internally-threaded element, while the screw mates jointly with the internal shoulder of the connector part and with the internally-threaded element, **characterised in that** the connector part (40) comprises a W-shaped groove (464) configured to mate with a W-shaped contour (226) of the upright (2), and **in that** the corner connector (4) comprises a sealing member (70), configured to be interposed between the W-shaped groove (464) and the W-shaped contour (226) when that W-shaped contour is located opposite the W-shaped groove.

2. The corner connector (4) according to the preceding claim, **characterised in that** the connector part (40) comprises bearing surfaces (460, 470, 476) which are configured to mate with the contour (206) of the upright (2) and are capable of transferring axial forces parallel to the axis of the upright.

3. The corner connector (4) according to any one of the preceding claims, **characterised in that** the connector part (40) comprises a first protuberance (472), **in that** the upright (2) defines a rear housing (210) with an opening (214), **in that** the first protuberance is configured to mate with the opening of the rear housing to immobilise the connector part in rotation relative to the upright and being capable of aligning the connector part relative to the upright and of transferring torsional forces between the upright and the connector piece.

4. The corner connector (4) according to any one of the preceding claims, **characterised in that** the connector part (40) comprises second protuberances (480, 482), which are configured to mate with the front housing (208) and are capable of aligning the connector part with respect to the upright (2) and of transferring shear and torsional forces between the upright and the connector.

5. The corner connector (4) according to any one of the preceding claims, **characterised in that** the sealing member (70) has an open contour.

6. The corner connector (4) according to any one of the preceding claims, **characterised in that** the sealing member (70) is made of an elastomer material, preferably of ethylene-propylene-diene monomer.

7. The corner connector (4) according to any one of the preceding claims, **characterised in that** the internally-threaded element (80) has a polygonal lateral surface (82) configured to lock the rotation of the internally-threaded element relative to the upright (2).

8. A frame (1) comprising at least two rails (3), an upright (2) and a corner connector (4), **characterized in that** the corner connector is according to any one of the preceding claims, **in that** the two rails are mechanically connected to the corner part (40) and together define a first plane, and **in that** the upright and the two rails together define a right-angled trihedral of which the corner connector is the vertex.
